# EUROPEAN PATENT APPLICATION

(11) **EP 4 773 749 A1**
(43) Date of publication of application: **08.07.2026**
(21) Application number: 25227412.1
(22) Date of filing: 29.12.2025
(51) Int. Cl.: H05K 9/00

(54) **ELECTRONIC DEVICE WITH ELECTROMAGNETIC SHIELDING**

(30) Priority: 07.01.2025 TW 114100634
(71) Applicant: Arcadyan Technology Corporation, Hsinchu City 30071 (TW)
(72) Inventor: TSAI, Ming-Hsun, 300 Hsinchu City (TW); WU, Chih-Wei, 300 Hsinchu City (TW); YAN, Jun-Yu, 300 Hsinchu City (TW)
(74) Representative: Krauns, Christian

(57) **Abstract**

An electronic device includes a first circuit board, a first shielding cover and a first solder. The first circuit board has a first surface, a second surface and a first edge. The first and second surfaces are on opposite sides. The first edge is on one side of the circuit board. The first shielding cover is disposed on the first surface and covers a first region of the first circuit board. The first shielding cover includes a first main body and first and second shielding elements. The first shielding element is connected between the first main body and the second shielding element and parallel to the first surface. The second shielding element is parallel to the first edge and perpendicular to the first surface. The first solder is located between the first main body and the first region to connect the first shielding cover to the first circuit board.

## Description

### BACKGROUND OF THE INVENTION

### Field of the Invention

The invention relates in general to an electronic device, and more particularly to an electronic device with electromagnetic shielding.

### Description of the Related Art

Electronic devices rely on many electronic components, such as central processing units or chipsets, to operate. The electronic components need to be shielded to protect them from electromagnetic interference. In addition, conventional electronic devices include components such as a main circuit board, a connector, and an electronic module (e.g., a wireless communication module). The connector is located on the main circuit board, and the circuit board of the electronic module is coupled to the main circuit board via the connector. The connector is generally manufactured in a plastic package. When the high-speed signal of the electronic module passes through the connector, high-frequency noise is radiated. This high-frequency noise is then received by the antenna of the electronic device, causing serious signal interference.

### SUMMARY OF THE INVENTION

The invention is directed to an electronic device with electromagnetic shielding for preventing signal interference.

According to one aspect of the present invention, an electronic device with electromagnetic shielding is provided, including a first circuit board, a first shielding cover, and a first solder. The first circuit board has a first surface, a second surface, and a first edge, the first surface and the second surface being located on opposite sides of the first circuit board, and the first edge being located on one side of the first circuit board. The first shielding cover is disposed on the first surface and covers a first region of the first circuit board. The first shielding cover includes a first mail body, a first shielding element, and a second shielding element. The first shielding element is connected between the first mail body and the second shielding element and is parallel to the first surface. The second shielding element is parallel to the first edge and perpendicular to the first surface. The first solder is located between the first mail body and the first region to connect the first shielding cover to the first circuit board.

The above and other aspects of the invention will become better understood with regard to the following detailed description of the preferred but non-limiting embodiment(s). The following description is made with reference to the accompanying drawings.

### BRIEF DESCRIPTION OF THE DRAWINGS

FIG. 1 and FIG. 2 are respectively schematic diagrams of the front and side views of an electronic device with electromagnetic shielding according to an embodiment of the present invention.
FIG. 3 and FIG. 4 are respectively schematic diagrams of the front and side views of an electronic device with electromagnetic shielding according to another embodiment of the present invention.

### DETAILED DESCRIPTION OF THE INVENTION

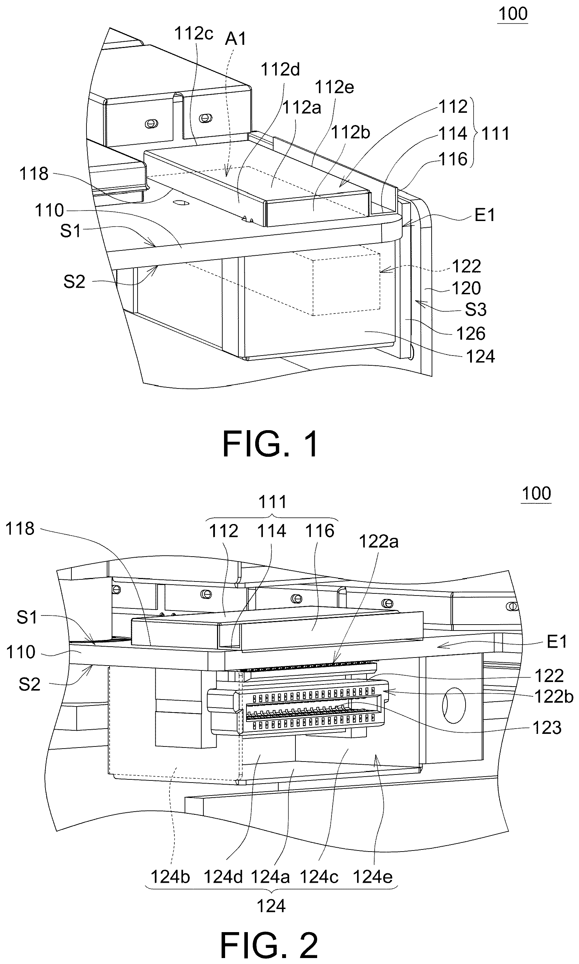

Referring to FIG. 1 and FIG. 2, schematic diagrams of the front and side views of an electronic device 100 with electromagnetic shielding according to an embodiment of the present invention are respectively illustrated. As shown in FIG. 1, the electronic device 100 includes a first circuit board 110, a first shielding cover 111, and a first solder 118. The first circuit board 110 has a first surface S1, a second surface S2, and a first edge E1. The first surface S1 and the second surface S2 are located on opposite sides of the first circuit board 110. The first surface S1 may be an upper surface, and the second surface S2 may be a lower surface. Alternatively, the first surface S1 may be a lower surface, and the second surface S2 may be an upper surface.

Furthermore, the first shielding cover 111 is disposed on the first surface S1 of the first circuit board 110 and covers a first region A1 of the first circuit board 110. The first region A1 is, for example, an electronic component packaging area for mounting an electronic component (not shown) on the first circuit board 110. A distance is maintained between the first region A1 and the first edge E1, that is, the first region A1 is not directly adjacent to the first edge E1. This prevents accidental damage to the first region A1 during the cutting process of the first circuit board 110, or prevents solder from flowing along the first edge E1 when mounting the electronic component during the soldering process. The first shielding cover 111 covers the first region A1, protecting the electronic component from electromagnetic interference. In one embodiment, the electronic component may be a chipset, a system-on-chip (SoC), or other processor. SoC is an integrated circuit that integrates an electronic system into a single chip and is configured to process digital signals, analog signals, or mixed digital and analog signals.

As shown in FIG. 1, the first shielding cover 111 includes a first main body 112, a first shielding element 114, and a second shielding element 116. The first main body 112 is a hollow metal cover, such as one-piece stamped metal sheet. The first main body 112 may include, but is not limited to, an upper cover 112a, a front cover 112b, a rear cover 112c, a left cover 112d, and a right cover 112e. The upper cover 112a is connected to the front cover 112b, the rear cover 112c, the left cover 112d, and the right cover 112e, respectively, to seal the electronic components within the first main body 112. In the present embodiment, the first main body 112 and the first region A1 of the first circuit board 110 can be joined via a first solder 118 (e.g., solder paste) to solder the first shielding cover 111 to the first surface S1 of the first circuit board 110.

In other words, the first solder 118 can be located between the first main body 112 and the first region A1 to connect the first shielding cover 111 and the first circuit board 110. A distance is maintained between the first solder 118 and the edge of the first circuit board 110 (i.e., the first edge E1). Even when the first solder 118 (e.g., solder paste) melts into liquid during the baking process, a small amount of the liquid solder paste flows between the first shielding element 114 and the first circuit board 110 due to a siphon effect. However, the liquid solder paste does not completely cover the entire surface of the first shielding element 114 facing the first circuit board 110.

As shown in FIGS. 1 and 2, the first edge E1 is located on the side of the first circuit board 110 facing the second circuit board 120. The first shielding element 114 is connected between the first main body 112 and the second shielding element 116, and the first shielding element 114 is parallel to the first surface S1. That is, the first shielding element 114 is disposed on one side (e.g., the right side) of the first main body 112, such that the first shielding element 114 is connected to the right cover 112e of the first main body 112. The first shielding element 114 extends horizontally toward the second circuit board 120 and reaches the first edge E1 of the first circuit board 110.

Furthermore, the second shielding element 116 is connected to the first shielding element 114. The second shielding element 116 is substantially parallel to the first edge E1 and perpendicular to the first surface S1. That is, the second shielding element 116 and the first shielding element 114 are substantially perpendicularly connected to form an L-shaped shielding structure. In one embodiment, the first main body 112, the first shielding element 114, and the second shielding element 116 can be stamped from a single piece of metal, or can be formed by combining different metal sheets.

As can be seen from the above description, the first shielding cover 111 of the present embodiment includes not only the existing first main body 112, but also a first shielding element 114 and a second shielding element 116 connected to one side of the first main body 112, so that the shielding area of the first shielding cover 111 is increased and closer to the first edge E1 of the first circuit board 110.

Referring to FIG. 1, the electronic device 100 also includes a second circuit board 120, a connecting element 122, a shielding housing 124, and a buffer element 126. The second circuit board 120 is disposed on one side of the first circuit board 110 and has a third surface S3. The third surface S3 is adjacent to the first edge E1 of the first circuit board 110 and is parallel to the second shielding element 116. In other words, the first circuit board 110 and the second circuit board 120 intersect substantially perpendicularly, and the first circuit board 110 and the second circuit board 120 can be electrically connected via the connecting element 122.

As shown in FIGS. 1 and 2, the connecting element 122 may include, but is not limited to, a right-angle board-to-board connector, one end 122a of the connecting element 122 is connected to the second surface S2 of the first circuit board 110, and the other end 122b of the connecting element 122 is connected to the third surface S3 of the second circuit board 120. The connecting element 122 has a plurality of electrical terminals 123 for transmitting signals. For example, the first circuit board 110 may include, but is not limited to, a circuit board for a Wi-Fi wireless communication module, and the second circuit board 120 may include, but is not limited to, a circuit board for a high-frequency communication module such as 4G/5G high-frequency communication. To prevent high-frequency noise radiated by the high-speed signal of the connecting element 122 from being received by the antenna of the electronic device 100 and causing severe signal interference (or cross-talk), the connecting element 122 must be disposed in the shielding housing 124. As shown in FIG. 2, the shielding housing 124 is disposed on the second surface S2 of the first circuit board 110. The shielding housing 124 may include, but is not limited to, a bottom cover 124a, a front cover 124b, a rear cover 124c, a side cover 124d, and an opening 124e. The bottom cover 124a is connected to the front cover 124b, the rear cover 124c, and the side cover 124d, respectively, to enclose the connecting element 122 within the shielding housing 124. In the present embodiment, the shielding housing 124 and the second surface S2 of the first circuit board 110 may be joined via solder or other adhesive to weld or otherwise secure the shielding housing 124 to the second surface S2 of the first circuit board 110. In the present embodiment, the shielding housing 124 is a hollow metal cover, such as one-piece stamped metal sheet. The opening 124e of the shielding housing 124 faces the third surface S3 of the second circuit board 120, allowing the electrical terminals 123 of the connecting element 122 to connect to the second circuit board 120 via the opening 124e.

As shown in FIG. 1, the buffer element 126 is disposed on the third surface S3 of the second circuit board 120. The buffer element 126 extends substantially along the third surface S3 and abuts between the first circuit board 110 and the second circuit board 120. The buffer element 126 may include, but is not limited to, conductive foam. The buffer element 126 can be compressed by the second shielding element 116 and the first edge E1 of the first circuit board 110, causing the buffer element 126 to be recessed, thereby ensuring close contact between the second shielding element 116 and the first edge E1. Furthermore, the buffer element 126 can be disposed between the shielding housing 124 and the second circuit board 120. The buffer element 126 can be compressed by the shielding housing 124, causing the buffer element 126 to be recessed, thereby ensuring close contact with the shielding housing 124.

As can be seen from the above description, the shielding housing 124, the buffer element 126, and the first shielding cover 111 located above the first circuit board 110 can prevent high-frequency noise from radiating through the gap between the first circuit board 110 and the second circuit board 120, thereby achieving the effect of preventing electromagnetic interference.

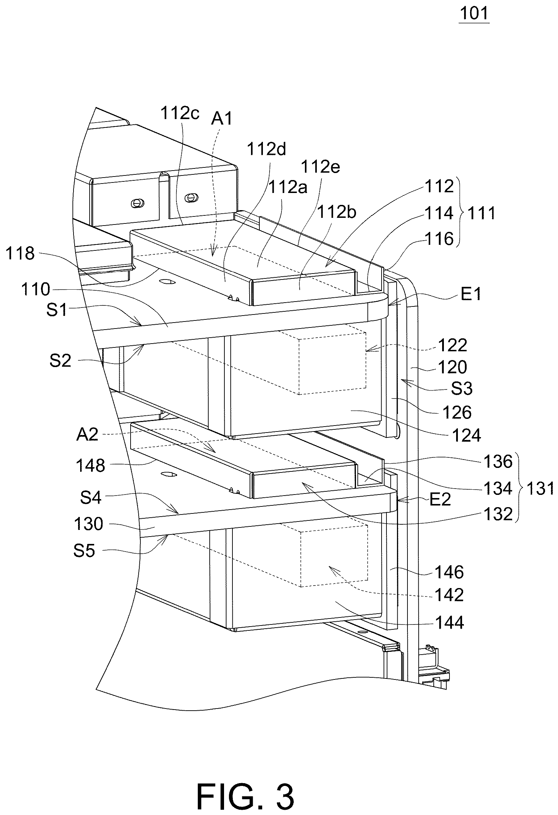

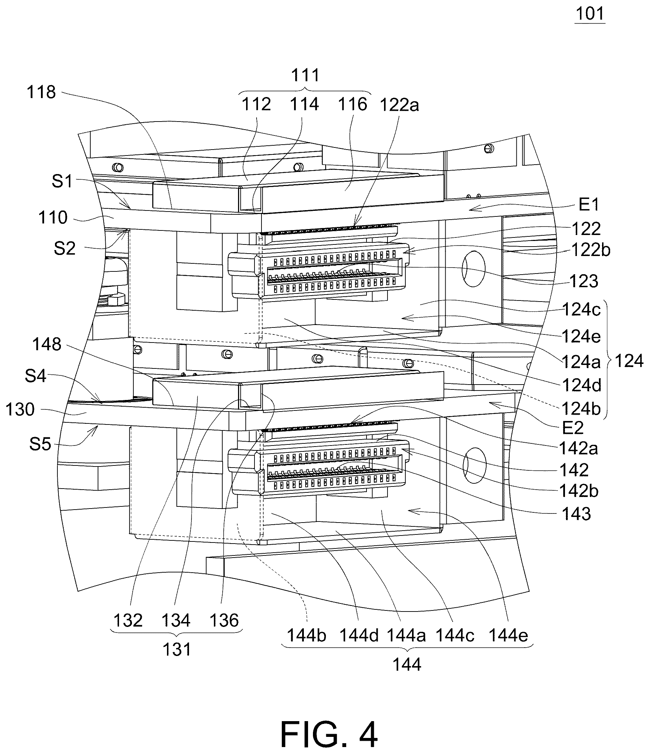

Referring to FIGS. 3 and 4, schematic diagrams of the front and side views of an electronic device 101 with electromagnetic shielding according to another embodiment of the present invention are respectively illustrated. As shown in FIG. 3, the electronic device 101 includes a first circuit board 110, a first shielding cover 111, a first solder 118, a second circuit board 120, a third circuit board 130, a second shielding cover 131, and a second solder 148. The configuration of the first circuit board 110, the first shielding cover 111, the first solder 118, and the second circuit board 120 is as described in the above embodiment and does not repeat here. Furthermore, the configuration of the third circuit board 130, the second shielding cover 131, and the second solder 148 is substantially the same as the configuration of the first circuit board 110, the first shielding cover 111, and the first solder 118, as described in detail below.

As shown in FIG. 3, the third circuit board 130 has a fourth surface S4, a fifth surface S5, and a second edge E2. The fourth surface S4 and the fifth surface S5 are located on opposite sides of the third circuit board 130, and the second edge E2 is located on a side of the third circuit board 130 adjacent to the second circuit board 120.

The second shielding cover 131 is disposed on the fourth surface S4 and covers a second region A2 of the third circuit board 130. The second region A2 is, for example, an electronic component packaging area for an electronic component (not shown) to be disposed on the third circuit board 130. The second shielding cover 131 covers the second region A2 to protect the electronic component from electromagnetic interference. In one embodiment, the electronic component may be a chipset, a system-on-chip (SoC), or other processor. SoC is an integrated circuit that integrates an electronic system into a single chip and is configured to process digital signals, analog signals, or mixed digital and analog signals.

As shown in FIG. 3, the second shielding cover 131 includes a second main body 132, a third shielding element 134, and a fourth shielding element 136. The second main body 132 is a hollow metal cover, such as one-piece stamped metal sheet. The second main body 132 has a substantially similar structure to the first main body 111, where the top cover is connected to the front cover, rear cover, left cover, and right cover, respectively, to seal the electronic component within the second main body 132. In the present embodiment, the second main body 132 and the second region A2 of the third circuit board 130 can be joined via the second solder 148, and thereby the second shielding cover 131 can be soldered to the fourth surface S4 of the third circuit board 130.

In other words, the second solder 148 can be located between the second main body 132 and the second region A2 to connect the second shielding cover 131 and the third circuit board 130. A distance is maintained between the second solder 148 and the edge of the third circuit board 130 (i.e., the second edge E2). Even when the second solder 148 (e.g., solder paste) melts into liquid during the baking process, a small amount of the liquid solder paste flows between the third shielding element 134 and the third circuit board 130 due to a siphon effect. However, the liquid solder paste does not completely cover the entire surface of the third shielding element 134 facing the second circuit board 120.

As shown in FIGS. 3 and 4, the second edge E2 is located on the side of the third circuit board 130 facing the second circuit board 120. The third shielding element 134 is connected between the second main body 132 and the fourth shielding element 136, and the third shielding element 134 is parallel to the fourth surface S4. That is, the third shielding element 134 is disposed on one side (e.g., the right side) of the second main body 132, such that the third shielding element 134 is connected to the right cover of the second main body 132. The third shielding element 134 extends horizontally toward the second circuit board 120 and reaches the second edge E2 of the third circuit board 130.

In addition, the fourth shielding element 136 is connected to the third shielding element 134. The fourth shielding element 136 is substantially parallel to the second edge E2 and perpendicular to the fourth surface S4. That is, the fourth shielding element 136 and the third shielding element 134 are substantially perpendicularly connected to form an L-shaped shielding structure. In one embodiment, the second main body 132, the third shielding element 134, and the fourth shielding element 136 can be stamped from a single piece of metal, or can be formed by combining different metal sheets.

As can be seen from the above description, the second shielding cover 131 of the present embodiment includes not only the existing second main body 132, but also the third shielding element 134 and the fourth shielding element 136 connected to one side of the second main body 132, so that the shielding area of the second shielding cover 131 is increased and closer to the second edge E2 of the third circuit board 130.

Referring to FIG. 3, the electronic device 101 also includes a connecting element 142, a shielding housing 144, and a buffer element 146. The second circuit board 120 is disposed on the same side of the first circuit board 110 and the third circuit board 130, and the third surface S3 of the second circuit board 120 is adjacent to the second edge E2 of the third circuit board 130. The third surface S3 is substantially parallel to the fourth shielding element 136. In other words, the third circuit board 130 and the second circuit board 120 intersect substantially perpendicularly, and the third circuit board 130 and the second circuit board 120 can be electrically connected via the connecting element 142.

As shown in FIGS. 3 and 4, the connecting element 142 may include, but is not limited to, a right-angle board-to-board connector, one end 142a of the connecting element 142 is connected to the fifth surface S5 of the third circuit board 130, and the other end 142b of the connecting element 142 is connected to the third surface S3 of the second circuit board 120. The connecting element 142 has a plurality of electrical terminals 143 for transmitting signals. For example, the third circuit board 130 may include, but is not limited to, a circuit board for a Wi-Fi wireless communication module, and the second circuit board 120 may include, but is not limited to, a circuit board for a high-frequency communication module such as 4G/5G high-frequency communication. To prevent high-frequency noise radiated by the high-speed signal of the connecting element 142 from being received by the antenna of the electronic device 101 and causing severe signal interference (or crosstalk), the connecting element 142 must be disposed in a shielding housing 144.

As shown in FIG. 4, the shielding housing 144 is disposed on the fifth surface S5 of the third circuit board 130. The shielding housing 144 may include, but is not limited to, a bottom cover 144a, a front cover 144b, a rear cover 144c, a side cover 144d, and an opening 144e. The bottom cover 144a is connected to the front cover 144b, the rear cover 144c, and the side cover 144d, respectively, to enclose the connecting element 142 within the shielding housing 144. In the present embodiment, the shielding housing 144 and the fifth surface S5 of the third circuit board 130 may be joined via solder or other adhesive to weld or otherwise secure the shielding housing 144 to the fifth surface S5 of the third circuit board 130. In the present embodiment, the shielding housing 144 is a hollow metal cover, such as one-piece stamped metal sheet. The opening 144e of the shielding housing 144 faces the third surface S3 of the second circuit board 120, allowing the electrical terminals 143 of the connecting element 142 to connect to the second circuit board 120 via the opening 144e.

As shown in FIG. 3, the buffer element 146 is disposed on the third surface S3 of the second circuit board 120. The buffer element 146 extends substantially along the third surface S3 and abuts between the third circuit board 130 and the second circuit board 120. The buffer element 146 may include, but is not limited to, conductive foam. The buffer element 146 can be compressed by the fourth shielding element 136 and the second edge E2 of the third circuit board 130, causing the buffer element 146 to be recessed, thereby ensuring close contact between the fourth shielding element 136 and the second edge E2. Furthermore, the buffer element 146 can be disposed between the shielding housing 144 and the second circuit board 120. The buffer element 146 can be compressed by the shielding housing 144, causing the buffer element 146 to be recessed, thereby ensuring close contact with the shielding housing 144.

As can be seen from the above description, the shielding housing 144, the buffer element 146, and the second shielding cover 131 located above the third circuit board 130 prevent high-frequency noise from radiating through the gap between the third circuit board 130 and the second circuit board 120, thereby achieving the effect of preventing electromagnetic interference. Furthermore, when viewed from above the first surface S1, the first circuit board 110 is located above and substantially parallel to the third circuit board 130, and the first circuit board 110 can completely cover the second shielding cover 131. Through the shielding design described in the present embodiment, the first shielding cover 111 and the second shielding cover 131 can be used in an electronic device 101 having multiple circuit boards and multiple connecting components stacked one above the other. Within the existing structure of the first main body 112 and the second main body 132, the first shielding cover 111 and the second shielding cover 131 are not restricted by the existing space. More shielding area can be extended from the first shielding cover 111 and the second shielding cover 131 to the sides of the circuit boards, thereby enhancing electromagnetic interference protection.

While the invention has been described by way of example and in terms of the preferred embodiment(s), it is to be understood that the invention is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. An electronic device (100) with electromagnetic shielding, comprising:
a first circuit board (110) having a first surface (S1), a second surface (S2), and a first edge (E1), the first surface (S1) and the second surface (S2) being located on opposite sides of the first circuit board (110), and the first edge (E1) being located on one side of the first circuit board (110);
a first shielding cover (111) disposed on the first surface (S1) and covering a first region (A1) of the first circuit board (110), the first shielding cover (111) comprising a first main body (112), a first shielding element (114), and a second shielding element (116), the first shielding element (114) being connected between the first main body (112) and the second shielding element (116) and parallel to the first surface (S1), and the second shielding element (116) being parallel to the first edge (E1) and perpendicular to the first surface (S1), wherein the first shielding element (114) does not extend beyond the first edge (E1) of the first circuit board (110); and
a first solder (118) being located between the first main body (112) and the first region (A1) to connect the first shielding cover (114) to the first circuit board (110).

2. The electronic device with electromagnetic shielding according to claim 1, further comprising a second circuit board (120) having a third surface (S3) adjacent to the first edge (E1) and parallel to the second shielding element (116).

3. The electronic device with electromagnetic shielding according to claim 2, further comprising a buffer element (126) disposed on the third surface (S3), the buffer element (126) contacting the second shielding element (116) and the first edge (E1).

4. The electronic device with electromagnetic shielding according to claim 2 or 3, further comprising a connecting element (122) disposed on the second surface (S2) and the third surface (S1), the connecting element (122) electrically connecting the first circuit board (110) and the second circuit board (120).

5. The electronic device with electromagnetic shielding according to claim 4, further comprising a shielding housing (124) disposed on the second surface (S2) and covering the connecting element (122), the shielding housing (124) having an opening (124e) facing the third surface (S3).

6. The electronic device with electromagnetic shielding according to anyone of the claims 2 to 5, further comprising:
a third circuit board (130) having a fourth surface (S4), a fifth surface (S5), and a second edge (E2), the fourth surface (S4) and the fifth surface (S5) being located on opposite sides of the third circuit board (130), and the second edge (E2) being located on one side of the third circuit board (130);
a second shielding cover (144) disposed on the fourth surface (S5) and covering a second region (A2) of the third circuit board (130), the second shielding cover (144) comprising a second main body (132), a third shielding element (134), and a fourth shielding element (136), the third shielding element (134) being connected between the second main body (132) and the fourth shielding element (136) and parallel to the fourth surface (S4), and the fourth shielding element (136) being parallel to the second edge (E2) and perpendicular to the fourth surface (S4); and
a second solder (148) being located between the second main body (132) and the second region (A2) to connect the second shielding cover (131) to the third circuit board (130).

7. The electronic device with electromagnetic shielding according to claim 6, wherein the third surface (S3) is adjacent to the second edge (E2) and parallel to the fourth shielding element (136).

8. The electronic device with electromagnetic shielding according to claim 6 or 7, further comprising a buffer element (146) disposed on the third surface (S3), the buffer element (146) contacting the fourth shielding element (136) and the second edge (E2).

9. The electronic device with electromagnetic shielding according to anyone of the claims 6 to 8, further comprising a connecting element (142) disposed on the third surface (S3) and the fifth surface (S4), the connecting element (142) electrically connecting the second circuit board (120) and the third circuit board (130).

10. The electronic device with electromagnetic shielding according to claim 9, further comprising a shielding housing (144) disposed on the fifth surface (S5) and covering the connecting element (142), the shielding housing (144) having an opening (144e) facing the third surface (S3).

11. The electronic device with electromagnetic shielding according to anyone of the claims 6 to 10, wherein, as viewed from above the first surface (S1), the first circuit board (110) completely covers the second shielding cover (131).
